# FASCICULE DE BREVET EUROPEEN

(11) **EP 2 960 955 B1**
(45) Date de publication et mention de la délivrance du brevet: **24.10.2018**
(21) Numéro de dépôt: 15173465.4
(22) Date de dépôt: 23.06.2015
(51) Int. Cl.: H01L 41/09, G01R 1/067, H01H 57/00

(54) **DISPOSITIF DE CONNEXION ELECTRIQUE COMPORTANT DES ELEMENTS DE CONNEXION A POSITION COMMANDABLE**
ELEKTRISCHE VERBINDUNGSVORRICHTUNG, DIE VERBINDUNGSELEMENTE MIT EINER STEUERBAREN POSITION UMFASST
ELECTRIC CONNECTION DEVICE COMPRISING CONNECTION ELEMENTS WITH CONTROLLABLE POSITION

(30) Priorité: 24.06.2014 FR 1455858
(43) Date de publication de la demande: 30.12.2015
(73) Titulaire: Commissariat à l'Énergie Atomique et aux Énergies Alternatives, 75015 Paris (FR)
(72) Inventeur: BEN JAMAA, Haykel, 38000 GRENOBLE (FR); REY, Patrice, 38430 SAINT JEAN DE MOIRANS (FR)
(74) Mandataire: Brevalex

(56) Documents cités:
- US-A- 4 697 118
- US-A- 5 268 571
- US-A1- 2005 242 687
- US-A1- 2009 085 432

## Description

### DOMAINE TECHNIQUE ET ART ANTÉRIEUR

L'invention concerne un dispositif de connexion électrique comportant des éléments de connexion électrique dont la position est configurable individuellement, ainsi qu'un procédé de réalisation d'un tel dispositif de connexion électrique. L'invention s'applique avantageusement à la réalisation d'une carte de test servant à tester un dispositif, ou circuit, électronique comportant des plots de contact dont au moins une partie sont destinés à être contactés par les éléments de connexion électrique du dispositif de connexion électrique formant la carte de test.

Dans le domaine du test de dispositifs électroniques, notamment lorsque les plots de contact d'un dispositif à tester sont réalisés avec un faible pas (par exemple inférieur à environ 100 µm), des dispositifs de connexion électrique réalisés sous la forme de cartes à pointes avec un faible pas sont utilisés. De telles cartes à pointes sont généralement dédiées aux dispositifs destinés à être testés. Ainsi, les pointes d'une telle carte sont agencées conformément aux plots de contact du dispositif destiné à être testé par cette carte.

Une difficulté consiste à adapter la carte à pointes en fonction des emplacements des plots de contact du dispositif à tester qui peuvent changer pendant la phase de conception du dispositif, générant ainsi des phases de conception et de fabrication supplémentaires et coûteuses des cartes à pointes adaptées à ces nouvelles configurations du dispositif testé. Une carte à pointes générique et reconfigurable est donc utile pour résoudre ce problème et réduire le temps de cycle et les coûts du produit final testé.

Le document US 4 862 077 décrit une solution dans laquelle la reconfigurabilité des pointes est assurée par un adaptateur mécanique amovible. Un modèle d'adaptateur mécanique correspond à chaque motif de reconfigurabilité. Un tel système implique toutefois de faire appel à un nouvel adaptateur à chaque modification du dispositif testé. De plus, un tel dispositif de test est encombrant à cause du mécanisme mécanique utilisé.

Les documents US 5 736 850 et US 2006/0170435 A1 décrivent des solutions dans lesquelles la reconfigurabilité des pointes elles-mêmes n'est pas possible, mais dont les connexions électriques reliées aux pointes sont reconfigurables de telle façon qu'une matrice de connexions reconfigurables est réalisée. De telles solutions donnent une certaine souplesse au système mais d'un point de vue mécanique, toutes les pointes restent en contact physique avec le dispositif testé. Or, ceci n'est pas souhaitable car cela augmente les risques d'endommager le dispositif testé car les plots de contact sont fragiles, notamment lorsqu'ils sont réalisés avec un faible pas.

Le document « Thermally Actuated Microprobes for a New Wafer Probe Card » de Y. Zhang et al., IEEE Journal of micromechanical systems. Vol. 8, n°1, mars 1999, pages 43-49, propose d'utiliser des pointes de test dont la position de chacune d'elles est configurable grâce à un bilame. Les bilames sont réalisés sous la forme de poutres incorporant un élément chauffant permettant de commander thermiquement la position des bilames. Les pointes se trouvent aux extrémités des poutres. Lorsque l'un des bilames n'est pas chauffé, la pointe associée à ce bilame se trouve dans une position de repos, c'est-à-dire une position dans laquelle la pointe n'est pas destinée à être en contact avec l'un des plots de contact du dispositif testé. Lorsque le bilame est chauffé, celui-ci se courbe et entraîne un déplacement de la pointe vers le plot de contact qui se trouve en face de la pointe.

Le document US 2009/0085432 A1 propose un commutateur de type MEMS comportant un poutre cantilever comportant un élément électriquement conducteur et destiné à être connecté à un plots de contact opposé.

Par rapport aux précédentes solutions, celle-ci a pour avantage de permettre aux pointes qui ne sont pas utilisées lors d'un test de ne pas être en contact avec les plots de contact du dispositif testé. Par contre, les bilames nécessitent, pour leur commande, une certaine résistance de chauffage qui implique de réaliser les poutres avec une surface relativement importante, ce qui est problématique dans le cas de dispositif à tester comportant des plots de contact réalisés avec un faible pas (par exemple inférieur à environ 100 µm). En outre, la commande thermique de la position des pointes est instable à cause de sa dépendance vis-à-vis de la température de l'environnement dans lequel se trouve la carte à pointes (c'est-à-dire les conditions de convexion dans la chambre de test ou dans la salle où l'équipement de test est placé), qui subit donc des conditions de température peu maîtrisées et souvent non reproductibles. Ainsi, une utilisation de la carte à pointes dans un environnement de température élevée peut par exemple engendrer des contacts parasites de certaines pointes avec les plots de contact alors que ces pointes devraient normalement être en position de repos et donc ne pas être contact avec les plots. Enfin, des contacts parasites peuvent également se produire du fait que la carte à pointes et/ou le dispositif testé ne sont pas parfaitement plans, ou raison de différences d'épaisseurs, de géométrie et de matériaux entre les plots de contact du dispositif testé et/ou entre les pointes.

### EXPOSÉ DE L'INVENTION

Un but de la présente invention est de proposer un dispositif de connexion électrique comportant des éléments de connexion électrique dont la position est configurable individuellement, et qui ne présente pas les inconvénients des solutions de l'art antérieur précédemment décrites.

Pour cela, la présente invention propose un dispositif de connexion électrique comportant au moins un substrat et un ou plusieurs premiers éléments de connexion électrique disposés sur une face avant du dispositif de connexion électrique, chaque premier élément de connexion électrique comportant :
- au moins un support dont au moins une première extrémité est ancrée au substrat telle qu'une partie du support soit suspendue au-dessus de la face avant, le support comportant au moins une portion de matériau piézoélectrique disposée entre deux électrodes et apte à déplacer ladite partie du support de manière bidirectionnelle sensiblement perpendiculairement à la face avant en fonction d'une valeur d'une tension électrique destinée à être appliquée sur les électrodes ;
- au moins un élément électriquement conducteur disposé sur ladite partie du support.

Ainsi, la position de chacun des premiers éléments de connexion électrique est configurable individuellement ce qui permet d'adapter la position de chacun des premiers éléments de connexion électrique par exemple en fonction de la configuration des plots de contact du dispositif électronique avec lesquels un contact électrique est recherché. Il est ainsi possible de choisir quels sont les premiers éléments de connexion électrique qui sont en contact avec le dispositif testé.

De plus, par rapport à des pointes dont la position est commandée par des bilames, l'utilisation d'un matériau piézoélectrique commandable électriquement rend compatible la réalisation des premiers éléments de connexion électrique avec un faible pas (par exemple inférieur à environ 100 µm ou 40 µm, ou entre environ 20 µm et 40 µm, voir même un pas inférieur à environ 20 µm). L'utilisation d'un matériau piézoélectrique pour commander la position des premiers éléments de connexion électrique permet en outre d'éviter toute influence de la température de l'environnement de fonctionnement du dispositif sur la position des premiers éléments de connexion électrique.

De plus, du fait que le déplacement soit bidirectionnel (ce que ne permet pas un bilame qui peut uniquement se courber selon une seule direction), il est possible par exemple de positionner chacun des premiers éléments de connexion électrique selon au moins trois positions : une première position dite de repos lorsqu'aucune tension de polarisation n'est appliquée aux bornes des électrodes, une deuxième position dite de contact dans laquelle l'élément électriquement conducteur est déplacé en direction du dispositif testé, et une troisième position dite de retrait dans laquelle l'élément électriquement conducteur est déplacé en direction de la face avant du dispositif de connexion et augmentant ainsi la distance entre l'élément électriquement conducteur et le dispositif testé. Or, l'utilisation d'un bilame comme proposé dans l'art antérieur ne permet pas d'avoir une position de retrait permettant d'éloigner certains des éléments de connexion électrique vis-à-vis du dispositif testé. Ainsi, le dispositif de connexion électrique selon l'invention permet d'éviter des contacts parasites de certains des éléments de contact électrique avec le dispositif testé.

Les premiers éléments de connexion électrique sont aptes à être couplés à des plots de contact d'un dispositif électronique auquel le dispositif de connexion électrique est destiné à être connecté. Les plots de contact du dispositif électronique sont mécaniquement indépendants du dispositif de connexion électrique.

Les premiers éléments de connexion électrique peuvent être disposés en matrice avec un pas inférieur à environ 100 µm.

Le support de chaque premier élément de connexion électrique peut être de forme allongée et s'étendre dans une direction sensiblement parallèle à la face avant.

Dans chaque premier élément de connexion électrique, l'élément électriquement conducteur peut être disposé au niveau d'une deuxième extrémité du support suspendue au-dessus de la face avant.

En variante, dans chaque premier élément de connexion électrique, une deuxième extrémité du support peut être ancrée au substrat, ladite partie du support suspendue au-dessus de la face avant pouvant se trouver entre les première et deuxième extrémités du support.

Chaque élément électriquement conducteur peut comporter au moins une portion de matériau électriquement conducteur dont une extrémité forme une pointe ou plusieurs pointes, chaque pointe pouvant être de forme sensiblement bombée (ou arrondie) ou plane ou pointue. De manière générale, la forme des éléments électriquement conducteurs peut être adaptée en fonction de la géométrie et des matériaux des plots de contact du dispositif destiné à être testé par le dispositif de connexion électrique. Le dispositif de connexion électrique peut former une carte à pointes.

Une forme est dite bombée lorsqu'elle représente une portion d'une sphère, telle qu'un hémisphère, ou qu'elle est de forme arrondie. Contrairement à une forme bombée, une forme est dite plane lorsqu'elle est définie dans un plan.

Le support de chaque premier élément de connexion électrique peut comporter en outre au moins une portion d'ancrage telle qu'une première des deux électrodes soit disposée entre ladite portion d'ancrage et la portion de matériau piézoélectrique, la portion d'ancrage assurant l'ancrage du support au substrat.

Le support de chaque premier élément de connexion électrique peut comporter au moins une portion électriquement conductrice sur laquelle l'élément électriquement conducteur peut être disposé. Une telle portion électriquement conductrice peut assurer la transmission de signaux depuis et/ou vers les éléments électriquement conducteurs destinés à être en contact avec le dispositif testé.

Dans ce cas, le support de chaque premier élément de connexion électrique peut comporter en outre au moins une portion diélectrique disposée entre la portion électriquement conductrice et une deuxième des deux électrodes. Cette portion diélectrique peut assurer ainsi l'isolation électrique entre la portion électriquement conductrice et la deuxième électrode.

Le dispositif de connexion électrique peut comporter en outre au moins un via électriquement conducteur traversant le substrat et relié à la portion électriquement conductrice du support de chaque premier élément de connexion électrique et à au moins un deuxième élément de connexion électrique disposé sur une face arrière du dispositif de connexion électrique. De tels vias peuvent assurer les liaisons électriques entre la face avant et la face arrière du dispositif de connexion électrique. Une interface de test peut être couplée à la face arrière du dispositif de connexion électrique, par l'intermédiaire des deuxièmes éléments de connexion électrique.

La portion électriquement conductrice du support de chaque premier élément de connexion électrique peut former un capot d'au moins une cavité disposée dans le support, l'élément électriquement conducteur pouvant être disposé au-dessus de la cavité. Une telle configuration permet de conférer une bonne souplesse mécanique aux premiers éléments de connexion électrique lorsque ces éléments sont appliqués contre des plots de contact du dispositif testé.

Le dispositif de connexion électrique peut comporter en outre :
- plusieurs couches diélectriques superposées et disposées sur le substrat et formant la face avant du dispositif de connexion électrique,
- plusieurs couches d'interconnexions électriques disposées dans les couches diélectriques et auxquelles sont reliées au moins les électrodes de chaque premier élément de connexion électrique.

Le dispositif de connexion électrique peut comporter en outre au moins une mémoire apte à mémoriser la valeur de la tension électrique destinée à être appliquée sur les électrodes de chaque premier élément de connexion électrique.

L'invention concerne également un procédé de réalisation d'un dispositif de connexion électrique, comportant la réalisation, à partir d'un substrat, d'un ou plusieurs premiers éléments de connexion électrique sur une face avant du dispositif de connexion électrique au moins par la mise en oeuvre des étapes suivantes :
- réalisation d'au moins une portion de matériau sacrificiel sur la face avant ;
- réalisation d'au moins un support dont au moins une première extrémité est ancrée au substrat telle qu'une partie du support soit disposée sur la portion de matériau sacrificiel, le support comportant au moins une portion de matériau piézoélectrique disposée entre deux électrodes ;
- réalisation d'au moins un élément électriquement conducteur sur ladite partie du support ;
- élimination de la portion de matériau sacrificiel, libérant ladite partie du support telle que la portion de matériau piézoélectrique soit apte à déplacer ladite partie du support de manière bidirectionnelle sensiblement perpendiculairement à la face avant en fonction d'une valeur d'une tension électrique destinée à être appliquée sur les électrodes.

Le procédé peut comporter en outre, préalablement à la réalisation du ou des premiers éléments de connexion électrique, la réalisation de plusieurs couches diélectriques superposées et disposées sur le substrat et formant la face avant du dispositif de connexion électrique, et de plusieurs couches d'interconnexions électriques disposées dans les couches diélectriques et auxquelles sont reliés au moins les électrodes du ou des premiers éléments de connexion électrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 5 représentent schématiquement une partie d'un dispositif de connexion électrique, objet de la présente invention, selon différents modes de réalisation ;
- les figures 6A à 6L représentent schématiquement des étapes d'un procédé de réalisation d'un dispositif de connexion électrique, objet de la présente invention, selon un mode de réalisation particulier;
- la figure 7 représente schématiquement un dispositif de connexion électrique, objet de la présente invention, et un dispositif électronique destiné à être testé par le dispositif de connexion électrique.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

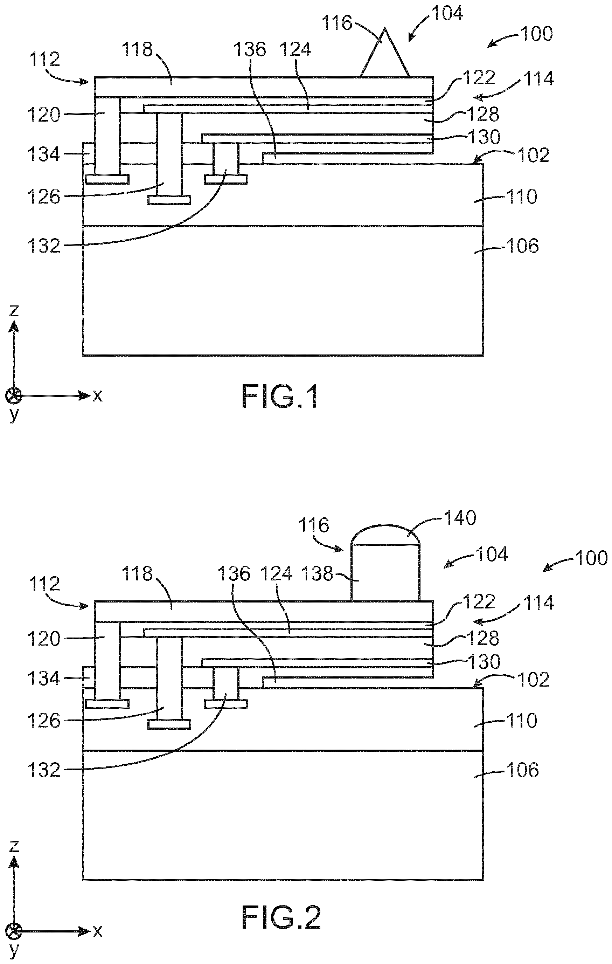

On se réfère tout d'abord à la figure 1 qui représente schématiquement une partie d'un dispositif de connexion électrique 100 selon un premier mode de réalisation. Dans ce premier mode de réalisation, le dispositif 100 correspond à une carte de test comprenant, sur une face avant 102, des premiers éléments de connexion électrique 104 destinés à être couplés à des plots de contact d'un dispositif testé. Sur la figure 1, bien que le dispositif 100 comporte un nombre d'éléments 104 par exemple égal à plusieurs centaines, ou plusieurs milliers ou plusieurs dizaines de milliers, et disposés par exemple en matrice, un seul élément 104 est représenté.

Le dispositif 100 comporte un substrat 106 comprenant par exemple du semi-conducteur tel que du silicium. Une ou plusieurs couches d'interconnexions électriques (BEOL, ou « Back-End Of Line »), non visibles sur la figure 1, sont disposées sur le substrat 106, du côté de la face avant 102, et forment, dans plusieurs couches diélectriques 110 comportant au moins un matériau minéral tel que du SiO₂, du SiON, du SiN, etc., et déposées sur une face avant du substrat 106, un ou plusieurs niveaux d'interconnexions électriques reliés notamment aux éléments 104.

Chaque élément 104 est ici réalisé sous la forme d'une membrane souple comportant une première extrémité 112 ancrée au substrat 106 et une deuxième extrémité 114 libre, c'est-à-dire non solidarisée au substrat 106, au niveau de laquelle est disposé un élément électriquement conducteur 116, correspondant à une pointe, ou un insert, de test dans ce premier mode de réalisation, destiné à être en contact ou non avec un plot de contact du dispositif testé selon la position de l'élément 104. L'élément 116 comporte avantageusement du métal tel que du cuivre, du tungstène, de l'aluminium, du nickel ou encore du rhodium, ou bien un semi-conducteur recouvert de métal. L'élément 116 est destiné à être appliqué contre un plot de contact du dispositif testé avec une force permettant une pénétration mécanique de l'élément 116 dans le plot de contact du dispositif testé. Le ou les matériaux de l'élément 116 sont choisis notamment en fonction de la dureté désirée pour former le contact avec le plot de contact du dispositif testé, et donc en fonction notamment de la fragilité de ce plot de contact.

L'élément 116 est disposé sur une portion électriquement conductrice 118 comportant ici une forme allongée et correspondant à un élément de la membrane souple. La portion 118 comporte au moins un matériau électriquement conducteur tel que du silicium dopé ou siliciuré, et/ou du métal (par exemple du cuivre, de l'aluminium, du tungstène ou du nickel, ou l'un de ceux décrits ci-dessus pour l'élément 116) et/ou du graphite. La portion 118 est reliée à l'un des niveaux d'interconnexions électriques par l'intermédiaire d'un premier plot conducteur 120.

Une portion diélectrique 122 est disposée entre la portion 118 et une première électrode 124 comportant par exemple un métal tel que du titane. La première électrode 124 est reliée à l'un des niveaux d'interconnexions électriques par l'intermédiaire d'un deuxième plot conducteur 126. La première électrode 124 est disposée sur une portion de matériau piézoélectrique 128, comportant par exemple du PZT et/ou de l'AIN, elle-même disposée sur une deuxième électrode 130. La deuxième électrode 130 est reliée à l'un des niveaux d'interconnexions électriques par l'intermédiaire d'un troisième plot conducteur 132. La deuxième électrode 130 et la portion 128 reposent sur une portion d'ancrage 134, par exemple en semi-conducteur tel que du silicium ou en un matériau diélectrique. Le plot conducteur 120 est isolé électriquement de la portion d'ancrage 134. Par exemple, lorsque la portion d'ancrage 134 comporte du semi-conducteur et que le plot conducteur 120 est par exemple en cuivre ou en tungstène, le plot conducteur 120 peut être entouré d'un matériau isolant électrique afin d'éviter un court-circuit entre le matériau conducteur du plot 120 et la portion d'ancrage 134. La portion d'ancrage 134 comporte une première partie reposant sur les couches diélectriques 110 et forme ainsi l'ancrage de la première extrémité 112 de l'élément 104 au substrat 106. Les plots conducteurs 120, 126 et 132 traversent cette première partie de la portion 134. Une deuxième partie de la portion 134 ne repose pas sur les couches diélectriques 110 mais est suspendue au-dessus de la face avant 102 en formant un espace 136 entre l'élément 104 et les couches diélectriques 110.

Lorsqu'une tension de polarisation est appliquée aux bornes des électrodes 124, 130 vias les plots conducteurs 126 et 132, la portion de matériau piézoélectrique 128 fléchit, sous l'effet de la polarisation électrostatique, soit en direction de la face avant 102, ce qui réduit l'épaisseur de l'espace 136 au niveau de la deuxième extrémité 114 (il peut même y avoir un contact entre la deuxième extrémité 114 et la face avant 102), soit dans une direction opposée augmentant ainsi l'épaisseur de l'espace 136 au niveau de la deuxième extrémité 114. La position de l'élément 116 le long de l'axe Z (axe orienté perpendiculairement à la direction selon laquelle s'étend la membrane formée par l'élément 104, l'axe Z étant également perpendiculaire au plan formé par la face avant 102) est donc fonction de la valeur de la tension de polarisation appliquée aux bornes des électrodes 124, 130. L'élément 116 peut donc être positionné selon au moins trois positions différentes : une première position basse lorsque la membrane fléchit en direction du substrat 106, une deuxième position intermédiaire lorsqu'aucune tension de polarisation n'est appliquée aux bornes des électrodes 124, 130 (cas représenté sur la figure 1), et une troisième position haute lorsque la membrane fléchit dans la direction opposée à celle vers le substrat 106. Ainsi, lorsque l'élément 116 est destiné à être en contact avec un plot de contact du dispositif testé, cet élément 116 peut être configuré en position haute. Lorsque l'élément 116 est destiné à ne pas être en contact avec un plot de contact se trouvant en regard de l'élément 116, celui-ci peut être soit laissé dans la position intermédiaire, soit configuré dans la position basse afin d'éviter tout risque de contact entre l'élément 116 et le plot de contact.

Les tensions électriques de polarisation peuvent être appliquées aux bornes des électrodes 124, 130 des éléments 104 soit par le biais d'un dispositif externe au dispositif 100 et reliés aux niveaux d'interconnexions électriques du dispositif 100, soit par le biais de points mémoires formés dans le dispositif 100, par exemple dans les couches diélectriques 110, et qui délivrent par exemple des signaux correspondants aux tensions de polarisation aux bornes des électrodes 124, 130.

Les éléments 116 peuvent être reliés à un système, ou interface, de test (non représenté sur la figure 1) via les portions 118, les plots 120 et les couches d'interconnexions électriques, pour injecter ou tracer un signal (tension ou courant) depuis ou vers les éléments 116.

En variante, chaque élément 104 peut comporter, à la place de l'élément 116 en forme de pointe, un élément 116 formant une multi-pointes. Un tel élément multi-pointes est bien adapté pour réaliser un contact avec des plots de contact du dispositif testé de forme arrondie et durs, correspondant par exemple à des billes métalliques, car dans ce cas, de tels plots de contact peuvent aisément s'insérer entre les pointes de chacun des éléments 116. Les éléments 116 sont ainsi bien centrés par rapport aux plots de contact du dispositif testé et évitent de dégrader les plots de contact. La distance entre les sommets de pointes d'un tel élément est par exemple inférieure à environ 1 µm.

La figure 2 représente schématiquement une partie du dispositif 100 selon un deuxième mode de réalisation. Comme sur la figure 1, bien que le dispositif 100 comporte plusieurs éléments 104, un seul de ces éléments 104 est représenté sur la figure 2.

Par rapport au premier mode de réalisation, chaque élément 104 comporte, à la place de l'élément 116 en forme de pointe, un élément 116 comportant une portion de matériau électriquement conducteur 138 surmontée d'une portion conductrice 140 (qui est bombée sur la figure 2, mais qui pourrait être plane). La portion conductrice 140 comporte par exemple un métal de fluage tel que du SnAg ou du NiAu, dont la dureté est inférieure au métal formant les éléments 116 en forme de pointes ou de multi-pointes comme dans le premier mode de réalisation. La portion conductrice 140 peut également comporter un métal plus dur tel que du tungstène. De tels éléments 104 sont bien adaptés pour réaliser un contact électrique avec des plots de contact du dispositif testé qui ne sont pas adaptés à un contact par des pointes, comme par exemple des plots en cuivre entourés d'isolant en formant une surface plane par exemple destinée à être reportée sur une puce par collage direct. De tels éléments 104 permettent de conserver l'intégrité des plots de contact du dispositif testé.

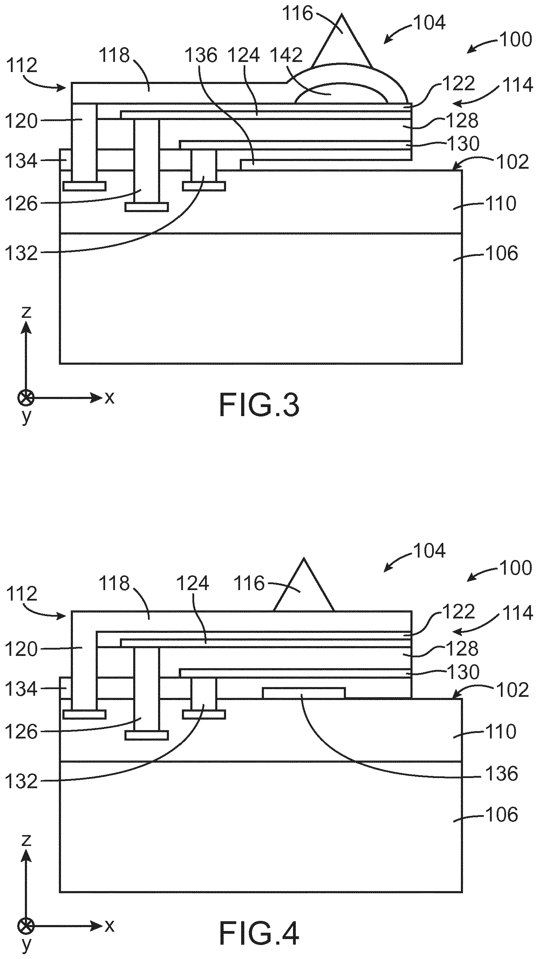

La figure 3 représente schématiquement une partie du dispositif 100 selon un troisième mode de réalisation. Comme sur les figures 1 et 2, bien que le dispositif 100 comporte plusieurs éléments 104, un seul de ces éléments 104 est représenté sur la figure 3.

Dans ce troisième mode de réalisation, la portion 118 comporte avantageusement du silicium dopé ou siliciuré. L'élément 116 correspond ici à une pointe de test comme dans le premier mode de réalisation.

Afin d'obtenir une certaine souplesse mécanique en termes de déplacement vertical des éléments 116 en dépit de leur faible pas et des éventuels défauts d'uniformité de hauteur des éléments 116 ou des plots de contact du dispositif testé, tout en ayant une pénétration des éléments 116 dans les plots de contact du dispositif testé qui soit assez profonde pour réaliser un bon contact ohmique entre les éléments 116 et les plots de contact, mais pas trop profonde pour éviter d'endommager les plots de contact et permettre aux éléments 116 d'être détachés des plots de contact après le test, chaque élément 116 est disposé sur une partie de la portion 118 formant, entre une face supérieure de la portion 122 et une face inférieure de la portion 118 se trouvant du côté de la portion 122, une cavité 142. Sur l'exemple de la figure 3, la cavité 142 comporte une paroi de fond formée par la portion 122. Les parois latérales et la paroi supérieure de la cavité 142 sont formées par la portion 118 qui repose sur la portion 122. La partie de la portion 118 formant les parois de la cavité 142 a, par rapport à la portion122, une forme bombée convexe, et forme un capot de la cavité 142. La cavité 142 est ici fermée, et les parties de la portion 118 délimitant la cavité 142 sont ancrées à la portion 122 sur toute la périphérie de la cavité 142.

Ainsi, lorsque les éléments 116 sont appliqués contre les plots de contact du dispositif testé, les portions 118 qui sont soumises à une force trop importante selon une direction sensiblement perpendiculaire à la face avant 102, peuvent se déformer selon cette direction et absorber ainsi une partie de cette force. Ces portions 118 forment des supports des éléments 116 présentant une bonne souplesse mécanique (bon overdrive).

La compensation de la déformation en hauteur pouvant être réalisée par de telles portions 118, c'est-à-dire la différence de position en hauteur maximale entre deux éléments 116 du dispositif 100 peut être de quelques dizaines de microns, par exemple entre environ 10 µm et 200 µm. Entre deux éléments 116 adjacents, cette différence peut être de l'ordre du micron voir moins, par exemple entre environ 0,5 µm et 1 µm.

Dans l'exemple de réalisation précédemment décrit, la portion 118 est en silicium dopé ou siliciuré, ou plus généralement en un matériau électriquement conducteur permettant à la portion 118 de présenter une certaine flexibilité ou souplesse. En variante, la portion 118 peut être formée par la superposition de plusieurs couches de matériau, par exemple un semi-conducteur recouvert d'une couche métallique.

En variante de ce troisième mode de réalisation, les éléments 116 peuvent être réalisés comme précédemment décrit en liaison avec le deuxième mode de réalisation, ou encore sous la forme d'une multi-pointes.

Il est également possible que les cavités 142 soient de forme rectangulaire ou carrée, conférant ainsi plus de souplesse aux portions 118 lorsqu'elles sont soumises à une force de pression depuis les éléments 116 en contact avec les plots de contact du dispositif testé. En variante, les cavités 142 peuvent avoir une forme autre que rectangulaire.

La figure 4 représente schématiquement une partie du dispositif 100 selon un quatrième mode de réalisation. Comme sur les figures précédentes, bien que le dispositif 100 comporte plusieurs éléments 104, un seul de ces éléments 104 est représenté sur la figure 4.

Par rapport au premier mode de réalisation précédemment décrit, la deuxième extrémité 114 de l'élément 104 n'est pas libre mais ancrée au substrat 106 par l'intermédiaire d'une partie de la portion d'ancrage 134. L'espace 136 est présent entre une partie de l'élément 134 (entre les deux extrémités 112, 114) et les couches diélectriques 110. L'élément 116 est en outre localisé en regard de l'espace 136.

Dans ce quatrième mode de réalisation, la déformation de l'élément 104 se traduit donc non pas par un déplacement de la deuxième extrémité 114 comme dans les précédents modes de réalisation, mais par une déformation concave ou convexe de l'élément 104 au niveau de la partie de l'élément 104 qui n'est pas ancrée au substrat, c'est-à-dire au niveau de l'espace 136, cette déformation étant fonction de la tension de polarisation appliquée aux bornes des électrodes 124, 130.

En variante de ce quatrième mode de réalisation, l'élément 116 peut être réalisé comme précédemment décrit en liaison avec le deuxième mode de réalisation, ou encore sous la forme d'une multi-pointes. De plus, une portion 118 formant une cavité 142 comme dans le troisième mode de réalisation peut également être utilisée dans ce quatrième mode de réalisation.

Dans tous les modes de réalisation précédemment décrits, le dispositif 100 peut comporter un ou plusieurs éléments mémoire 144 couplés aux électrodes 124, 130 des éléments 104 afin d'appliquer aux bornes de ces électrodes 124, 130 des tensions de polarisation dont les valeurs sont mémorisées dans le ou les éléments mémoire 144. Il est par exemple possible d'avoir, pour chaque élément 104, un élément mémoire 144 couplé à cet élément 104 et délivrant une tension de polarisation adaptée à cet élément 104 suivant le déplacement souhaité pour cet élément 104.

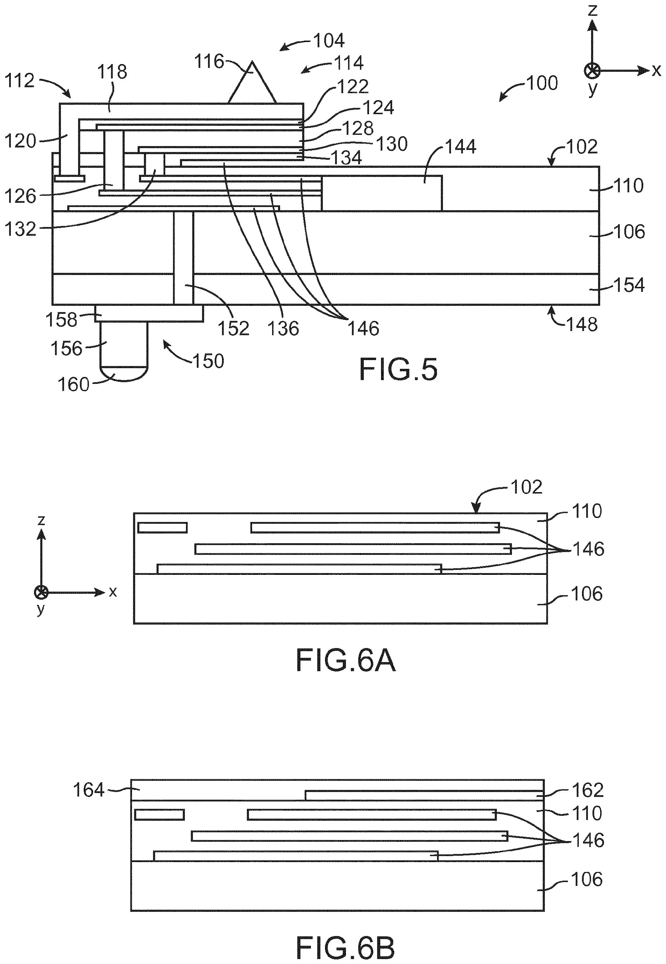

La figure 5 représente schématiquement une partie du dispositif 100 selon le premier mode de réalisation, dans lequel un élément mémoire 144 est relié aux électrodes 124, 130 de l'élément 104 par l'intermédiaire des couches d'interconnexions électriques 146 (similaires aux couches d'interconnexions électriques décrites dans les précédents modes de réalisation mais non représentées) formées dans les couches diélectriques 110.

Les éléments mémoire 144 peuvent correspondre à une mémoire volatile ou non volatile.

Le dispositif 100 comporte également, au niveau d'une face arrière 148, des deuxièmes éléments de connexion électrique 150 (un seul élément 150 est représenté sur la figure 5) reliés électriquement aux couches 146 par l'intermédiaire de vias conducteurs 152 traversant le substrat 106 depuis sa face avant jusqu'à sa face arrière, ainsi qu'une autre couche diélectrique 154 disposée sur la face arrière du substrat 106 et formant la face arrière 148 du dispositif 100. Les élément 150 comportent chacun des portions de matériau électriquement conducteur 156 disposées sur des parties d'une couche de nucléation 158 structurée et, au niveau de leur sommet, une autre portion de matériau électriquement conducteur 160, par exemple de forme bombée ou plate, comprenant par exemple un métal de fluage tel que du SnAg, du NiAu ou tout autre alliage adapté, et destinée à être par exemple en contact avec des plots de contact d'une interface de test couplée au dispositif 100 et permettant par exemple de relever des signaux de test délivrés par les éléments 116. Les portions 156 et 160 sont par exemple similaires à celles de l'élément 116 précédemment décrit en liaison avec le deuxième mode de réalisation. L'épaisseur de l'ensemble formé du substrat 106 et des couches 110, 154 est par exemple comprise entre environ 50 µm et 400 µm.

Les éléments présents au niveau de la face arrière 148 du dispositif 100 précédemment décrits peuvent être présents dans le dispositif 100 selon les modes de réalisation précédemment décrits lorsque le dispositif 100 est destiné à être couplé à un autre dispositif tel qu'une interface de test destiné à recevoir / envoyer des signaux aux éléments 104, notamment en présence d'éléments mémoire 144.

Dans tous les précédents modes de réalisation, le dispositif 100 peut comporter, sur et/ou dans le substrat 106, des dispositifs passifs (capacités, inductances, résistances) formant un ou plusieurs circuits permettant d'améliorer la qualité des signaux mesurés par les éléments 104, et/ou des dispositifs actifs comprenant par exemple des transistors et pouvant former des dispositifs de protection du dispositif testé, par exemple des dispositifs ESD (« Electro-Static Discharge »), et/ou des dispositifs de multiplexage et/ou de traitement numérique ou analogique des signaux mesurés.

Les figures 6A à 6L représentent des étapes d'un procédé de réalisation du dispositif de connexion 100 correspondant à celui représenté sur la figure 1. Sur ces figures, la réalisation d'un seul premier élément de connexion électrique 104 du dispositif 100 est représentée et décrite.

Le procédé est mis en oeuvre à partir du substrat 106. Les couches d'interconnexions électriques 146 et les couches diélectriques 110 sont tout d'abord réalisées sur la face avant du substrat 106, par exemple via des dépôts de type damascène. Ces étapes forment en outre la face avant 102 du dispositif 100 (figure 6A).

Une couche sacrificielle, comportant par exemple du polymère ou une résine, est ensuite déposée sur la face avant 102. Cette couche sacrificielle est ensuite structurée par gravure afin qu'une portion restante 162 de cette couche corresponde à l'espace 136 destiné à être réalisé entre la face avant 102 et l'élément 104. Une couche de semi-conducteur 164 destinée à former la portion d'ancrage 134 servant à l'ancrage de l'élément 104 au substrat 106 est ensuite déposée (figure 6B).

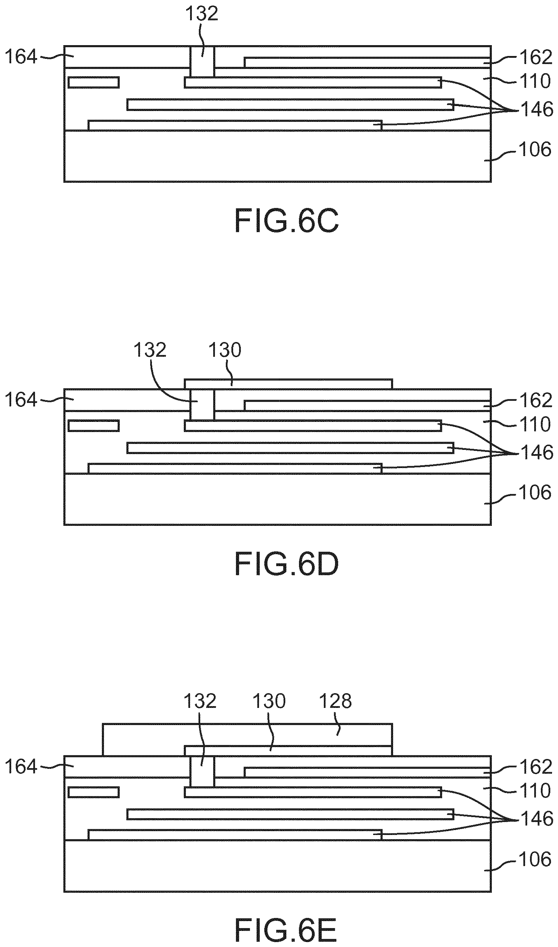

Le plot conducteur 132 destiné à relier l'électrode 130 aux couches d'interconnexions électriques 146 est ensuite réalisé. Pour cela, une gravure est réalisée à travers la couche 164 et les couches diélectriques 110 afin de former un trou d'accès aux couches d'interconnexions électriques 146 destinées à être reliées à l'électrode 130. Une couche diélectrique d'isolation, par exemple une couche de SiO₂, est ensuite déposée sur les parois du trou formé par gravure, puis un matériau conducteur, par exemple du cuivre, est ensuite déposé en remplissant le trou. Une planarisation des matériaux déposés avec arrêt sur la couche 164 est ensuite mise en oeuvre pour achever la réalisation du plot conducteur 132 (figure 6C).

L'électrode 130 est ensuite réalisée sur la couche 164 et en contact avec le plot conducteur 132, via un dépôt et une structuration d'un matériau électriquement conducteur (figure 6D).

La portion de matériau piézoélectrique 128 est ensuite réalisée sur l'électrode 130 et sur une partie de la couche 164, par dépôt et structuration du matériau piézoélectrique (figure 6E).

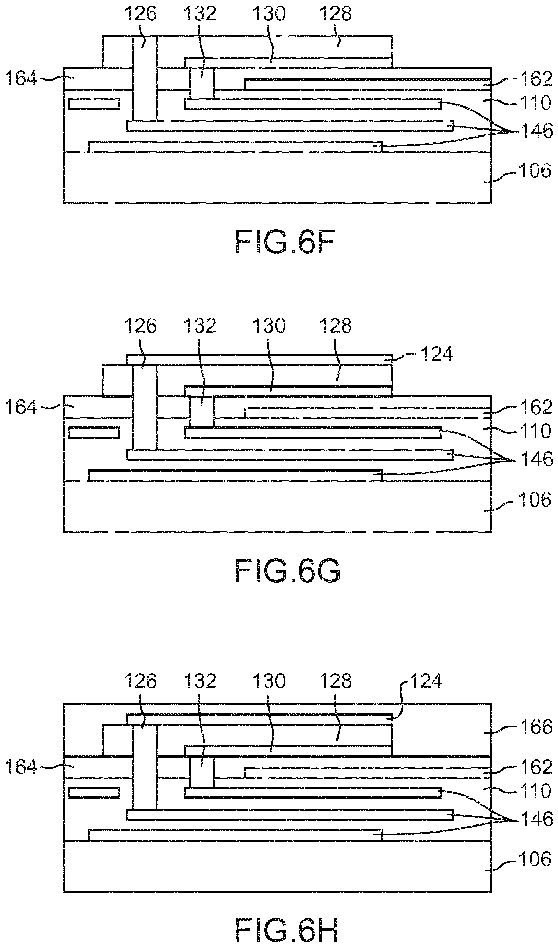

Le plot conducteur 126 destiné à relier l'électrode 124 aux couches d'interconnexions électriques 146 est ensuite réalisé. Pour cela, une gravure est réalisée à travers la portion 128, la couche 164 et les couches diélectriques 110 afin de former un accès aux couches d'interconnexions électriques 146 destinées à être reliées à l'électrode 124. Une couche diélectrique d'isolation, par exemple une couche de SiO₂, est ensuite déposée sur les parois du trou formé, puis un matériau conducteur, par exemple du cuivre, est ensuite déposé en remplissant le trou. Une planarisation des matériaux déposés, avec arrêt sur la portion 128, est ensuite mise en oeuvre pour achever la réalisation du plot conducteur 126 (figure 6F).

L'électrode 124 est ensuite réalisée sur la portion 128 et en contact avec le plot conducteur 126, via un dépôt et une structuration d'un matériau électriquement conducteur (figure 6G).

Une couche diélectrique 166 est ensuite déposée et planarisée en recouvrant la structure précédemment formée (figure 6H).

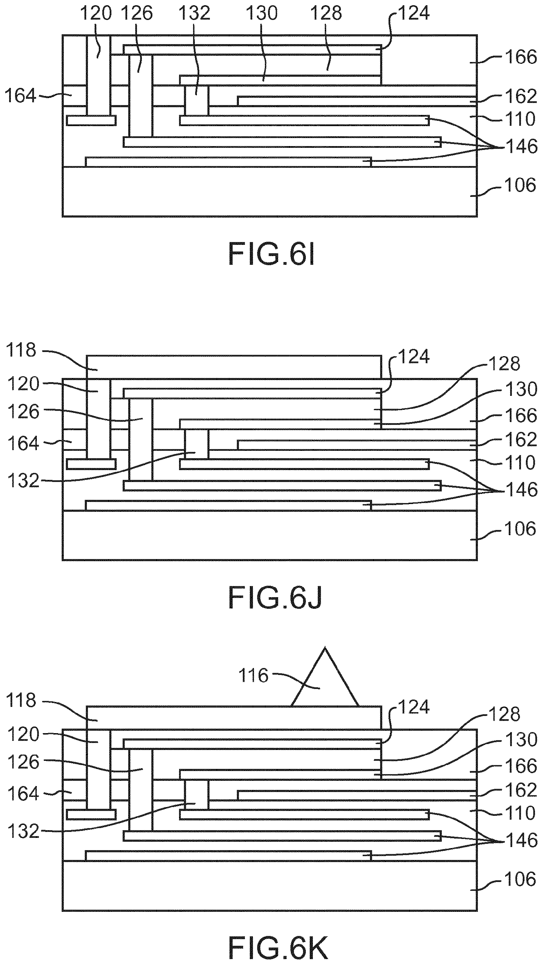

Le plot conducteur 120 est ensuite réalisé à travers les couches 166, 164 et 110 via la mise en oeuvre d'étapes analogues à celles mises en oeuvre pour la réalisation des plots conducteurs 132 et 126 (figure 6I).

La portion conductrice 118 est ensuite réalisée par dépôt et structuration d'un matériau électriquement conducteur sur la couche diélectrique 166, et en contact avec le plot conducteur 120 (figure 6J).

Un autre dépôt et une autre structuration d'un matériau électriquement conducteur permettent ensuite de réaliser l'élément 116 sur la portion 118 (figure 6K).

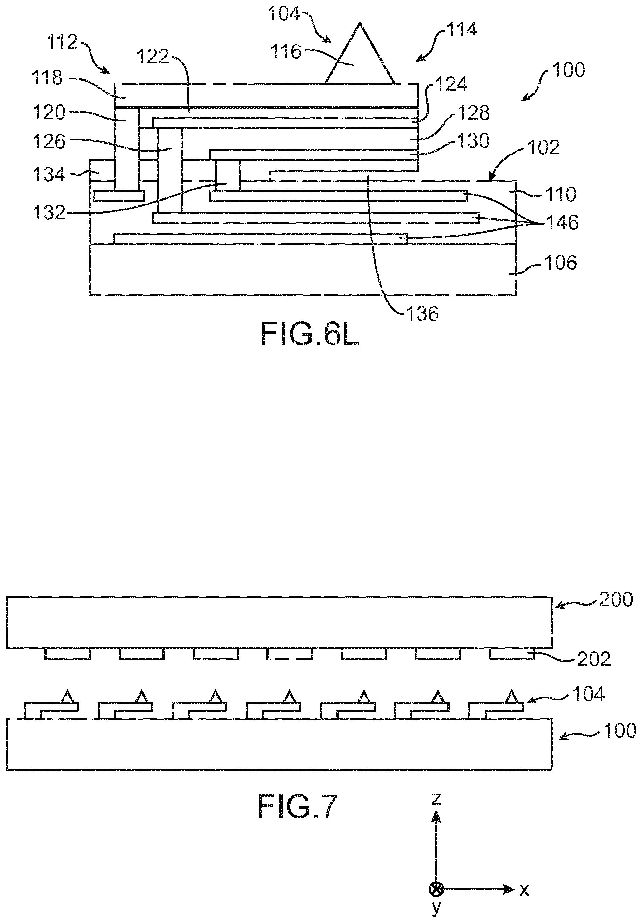

Le dispositif 100 est ensuite achevé en gravant la couche diélectrique 166 et la couche 164 telles qu'une partie restante de la couche 164 forme la portion 134 ancrant l'élément 104 au substrat 106 au niveau de sa première extrémité 112, et qu'une partie restante de la couche 166 forme la portion 122 assurant l'isolation électrique entre la portion 118 et l'électrode 124. La portion de matériau sacrificiel 162 est également gravée afin de former l'espace 136 et libérer ainsi la membrane formée par l'élément 104 au niveau de sa deuxième extrémité 114 (figure 6L).

Lorsque la portion 118 définit une cavité 142 comme précédemment décrit en liaison avec la figure 3, cette cavité 142 peut être obtenue via un dépôt d'une couche sacrificielle sur la couche diélectrique 166, comportant par exemple du polymère ou une résine. Cette couche sacrificielle est ensuite structurée par gravure afin qu'une portion restante de cette couche corresponde au volume de la cavité 142 destinée à être réalisée. Dans le cas d'une couche sacrificielle en polymère, une gravure de type plasma O₂ peut être mise en oeuvre pour former une portion de polymère de forme bombée pour la réalisation de la cavité 142 telle que représentée sur la figure 3. La forme bombée de la portion de matériau sacrificiel peut également être obtenue par la mise en oeuvre d'un reflux. La portion 118 est ensuite réalisée via un dépôt d'une couche électriquement conductrice, par exemple en métal tel que du Cu, de l'Al, du W, du Rh, du Rt, etc., et/ou du silicium dopé ou siliciuré, recouvrant la portion restante de la couche sacrificielle. Cette ou ces couches électriquement conductrices sont ensuite gravées afin que les portions restantes de cette ou des couches forment la portion 118, et forment le capot de cavité 142. Un ou plusieurs trous de libération sont ensuite réalisés à travers le capot, puis le matériau sacrificiel recouvert par la portion 118 est ensuite gravé à travers ce ou ces trous de libération, par exemple via une gravure sèche et/ou humide, formant la cavité 142.

Dans le cas d'un dispositif comportant des vias 152 traversant le substrat 106 comme représenté sur la figure 5, ces vias 152 sont réalisés à travers au moins une partie de l'épaisseur du substrat 106, au niveau de sa face avant, préalablement à la réalisation des couches d'interconnexions électriques 146. Pour cela, une gravure profonde est mise en oeuvre à travers la face avant du substrat 106, formant des trous à travers une partie de l'épaisseur du substrat 106 et au niveau desquels vont être formés les vias 152. Une couche diélectrique d'isolation, par exemple une couche de SiO₂, est ensuite déposée sur les parois des trous, puis une couche d'adhésion et de nucléation est déposée sur la couche diélectrique d'isolation par exemple via un dépôt électrolytique. Le matériau conducteur des vias 152, par exemple du cuivre, est ensuite déposé en remplissant les trous. Le substrat 106 peut par exemple avoir une épaisseur égale à 500 µm ou 750 µm, et les vias 152 peuvent être réalisés sur une hauteur égale à environ 100 µm.

De plus, lorsque le dispositif 100 comporte des deuxièmes éléments de connexion électrique 150 au niveau de sa face arrière 148 comme c'est le cas sur la figure 5, la structure obtenue peut être collée temporairement, au niveau de sa face avant 102, à un support formant une poignée mécanique. La face arrière du substrat 106 est ensuite amincie jusqu'à obtenir l'épaisseur souhaitée et atteindre notamment les vias 152. Une passivation de la face arrière peut ensuite être réalisée via le dépôt de la couche 154, puis des ouvertures sont réalisées à travers la couche 154 pour réaliser des reprises de contact des vias 152.

Un dépôt électrochimique ECD, par exemple par électrolyse, de la couche de nucléation 158 est ensuite réalisé au niveau de la face arrière 148. Une croissance électrolytique forme ensuite les portions 156. Les portions 160 sont ensuite réalisées par dépôt sur les portions 156. La couche de nucléation 158 est ensuite gravée afin de ne conserver que certaines portions faisant partie des éléments 150. Un éventuel reflux peut être mis en oeuvre lorsque le matériau des portions 160 est du SnAg, comme représenté sur la figure 5.

Enfin, le dispositif 100 obtenu est séparé de la poignée temporaire solidarisée à la face avant 102 du dispositif 100.

La figure 7 représente le dispositif 100 ainsi que le dispositif électronique 200 destiné à être testé. Les éléments 104 sont destinés à venir en contact avec des plots de contact 202 du dispositif 200. La position de chaque élément 104 selon l'axe Z est définie en fonction de la tension de polarisation appliquée aux bornes des électrodes de chacun des éléments 104.

## Revendications

1. Dispositif de connexion électrique (100) comportant au moins un substrat (106) et un ou plusieurs premiers éléments de connexion électrique (104) disposés sur une face avant (102) du dispositif de connexion électrique (100) tels qu'ils soient aptes à être couplés à des plots de contact (202) d'un dispositif électronique (200) auquel le dispositif de connexion électrique (100) est destiné à être connecté et qui sont mécaniquement indépendants du dispositif de connexion électrique (100), chaque premier élément de connexion électrique (104) comportant :
- au moins un support dont au moins une première extrémité (112) est ancrée au substrat (106) telle qu'une partie du support soit suspendue au-dessus de la face avant (102), le support comportant au moins une portion de matériau piézoélectrique (128) disposée entre deux électrodes (124, 130) et apte à déplacer ladite partie du support de manière bidirectionnelle sensiblement perpendiculairement à la face avant (102) en fonction d'une valeur d'une tension électrique destinée à être appliquée sur les électrodes (124, 130) ;
- au moins un élément électriquement conducteur (116) disposé sur ladite partie du support.

2. Dispositif de connexion électrique (100) selon la revendication 1, dans lequel les premiers éléments de connexion électrique (104) sont disposés en matrice avec un pas inférieur à environ 100 µm.

3. Dispositif de connexion électrique (100) selon l'une des revendications précédentes, dans lequel le support de chaque premier élément de connexion électrique (104) est de forme allongée et s'étend dans une direction sensiblement parallèle à la face avant (102).

4. Dispositif de connexion électrique (100) selon l'une des revendications précédentes, dans lequel, dans chaque premier élément de connexion électrique (104), l'élément électriquement conducteur (116) est disposé au niveau d'une deuxième extrémité (114) du support suspendue au-dessus de la face avant (102).

5. Dispositif de connexion électrique (100) selon l'une des revendications 1 à 3, dans lequel, dans chaque premier élément de connexion électrique (104), une deuxième extrémité (114) du support est ancrée au substrat (106), ladite partie du support suspendue au-dessus de la face avant (102) se trouvant entre les première (112) et deuxième (114) extrémités du support.

6. Dispositif de connexion électrique (100) selon l'une des revendications précédentes, dans lequel chaque élément électriquement conducteur (116) comporte au moins une portion de matériau électriquement conducteur dont une extrémité forme une pointe ou plusieurs pointes, chaque pointe étant de forme sensiblement bombée ou plane ou pointue.

7. Dispositif de connexion électrique (100) selon l'une des revendications précédentes, dans lequel le support de chaque premier élément de connexion électrique (104) comporte en outre au moins une portion d'ancrage (134) telle qu'une première (130) des deux électrodes soit disposée entre ladite portion d'ancrage (134) et la portion de matériau piézoélectrique (128), la portion d'ancrage (134) assurant l'ancrage du support au substrat (106).

8. Dispositif de connexion électrique (100) selon l'une des revendications précédentes, dans lequel le support de chaque premier élément de connexion électrique (104) comporte au moins une portion électriquement conductrice (118) sur laquelle l'élément électriquement conducteur (116) est disposé.

9. Dispositif de connexion électrique (100) selon la revendication 8, dans lequel le support de chaque premier élément de connexion électrique (104) comporte en outre au moins une portion diélectrique (122) disposée entre la portion électriquement conductrice (118) et une deuxième (124) des deux électrodes.

10. Dispositif de connexion électrique (100) selon l'une des revendications 8 ou 9, comportant en outre au moins un via électriquement conducteur (152) traversant le substrat (106) et relié à la portion électriquement conductrice (118) du support de chaque premier élément de connexion électrique (104) et à au moins un deuxième élément de connexion électrique (150) disposé sur une face arrière (148) du dispositif de connexion électrique (100).

11. Dispositif de connexion électrique (100) selon l'une des revendications 8 à 10, dans lequel la portion électriquement conductrice (118) du support de chaque premier élément de connexion électrique (104) forme un capot d'au moins une cavité (142) disposée dans le support, l'élément électriquement conducteur (116) étant disposé au-dessus de la cavité (142).

12. Dispositif de connexion électrique (100) selon l'une des revendications précédentes, comportant en outre :
- plusieurs couches diélectriques (110) superposées et disposées sur le substrat (106) et formant la face avant (102) du dispositif de connexion électrique (100),
- plusieurs couches d'interconnexions électriques (146) disposées dans les couches diélectriques (110) et auxquelles sont reliées au moins les électrodes (124, 130) de chaque premier élément de connexion électrique (104).

13. Dispositif de connexion électrique (100) selon l'une des revendications précédentes, comportant en outre au moins une mémoire (144) apte à mémoriser la valeur de la tension électrique destinée à être appliquée sur les électrodes (124, 130) de chaque premier élément de connexion électrique (104).

14. Procédé de réalisation d'un dispositif de connexion électrique (100), comportant la réalisation, à partir d'un substrat (106), d'un ou plusieurs premiers éléments de connexion électrique (104) sur une face avant (102) du dispositif de connexion électrique (100) tels qu'ils soient aptes à être couplés à des plots de contact (202) d'un dispositif électronique (200) auquel le dispositif de connexion électrique (100) est destiné à être connecté et qui sont mécaniquement indépendants du dispositif de connexion électrique (100), au moins par la mise en oeuvre des étapes suivantes :
- réalisation d'au moins une portion de matériau sacrificiel (162) sur la face avant (102) ;
- réalisation d'au moins un support dont au moins une première extrémité (112) est ancrée au substrat (106) telle qu'une partie du support soit disposée sur la portion de matériau sacrificiel (162), le support comportant au moins une portion de matériau piézoélectrique (128) disposée entre deux électrodes (124, 130) ;
- réalisation d'au moins un élément électriquement conducteur (116) sur ladite partie du support ;
- élimination de la portion de matériau sacrificiel (162), libérant ladite partie du support telle que la portion de matériau piézoélectrique (128) soit apte à déplacer ladite partie du support de manière bidirectionnelle sensiblement perpendiculairement à la face avant (102) en fonction d'une valeur d'une tension électrique destinée à être appliquée sur les électrodes (124, 130).

15. Procédé selon la revendication 14, comportant en outre, préalablement à la réalisation du ou des premiers éléments de connexion électrique (104), la réalisation de plusieurs couches diélectriques (110) superposées et disposées sur le substrat (106) et formant la face avant (102) du dispositif de connexion électrique (100), et de plusieurs couches d'interconnexions électriques (146) disposées dans les couches diélectriques (110) et auxquelles sont reliés au moins les électrodes (124, 130) du ou des premiers éléments de connexion électrique (104).

## Patentansprüche

1. Elektrische Verbindungsvorrichtung (100), umfassend wenigstens ein Substrat (106) und ein oder mehrere erste elektrische Verbindungselemente (104), die auf einer Vorderfläche (102) der elektrischen Verbindungsvorrichtung (100) derart angeordnet sind, das sie mit Kontaktpunkten (202) einer elektronischen Vorrichtung (200) gekoppelt werden können, an die die elektrische Verbindungsvorrichtung (100) angeschlossen werden soll, und die mechanisch von der elektrischen Verbindungsvorrichtung (100) unabhängig sind, wobei jedes erste elektrische Verbindungselement (104) umfasst:
- wenigstens einen Träger, von dem wenigstens ein erstes Ende (112) an dem Substrat (106) derart verankert ist, dass ein Teil des Trägers über der Vorderfläche (102) aufgehängt ist, wobei der Träger wenigstens einen Bereich aus piezoelektrischem Material (128) umfasst, der zwischen zwei Elektroden (124, 130) angeordnet und dazu ausgelegt ist, den Teil des Trägers in bidirektionaler Weise im Wesentlichen orthogonal zur Vorderfläche (102) als Funktion eines Werts einer elektrischen Spannung zu verlagern, die an die Elektroden (124, 130) angelegt werden soll;
- wenigstens ein elektrisch leitendes Element (116), das auf dem Teil des Trägers angeordnet ist.

2. Elektrische Verbindungsvorrichtung (100) nach Anspruch 1, bei der die ersten elektrischen Verbindungselemente (104) in einer Matrix mit einer Schrittweite von weniger als ungefähr 100 µm angeordnet sind.

3. Elektrische Verbindungsvorrichtung (100) nach einem der vorhergehenden Ansprüche, bei der der Träger jedes ersten elektrischen Verbindungselements (104) eine längliche Form hat und sich in einer Richtung im Wesentlichen parallel zur Vorderfläche (102) erstreckt.

4. Elektrische Verbindungsvorrichtung (100) nach einem der vorhergehenden Ansprüche, bei der bei jedem ersten elektrischen Verbindungselement (104) das elektrisch leitende Element (116) im Bereich eines zweiten Endes (114) des Trägers angeordnet ist, das über der Vorderfläche (102) aufgehängt ist.

5. Elektrische Verbindungsvorrichtung (100) nach einem der Ansprüche 1 bis 3, bei der bei jedem ersten elektrischen Verbindungselement (104) ein zweites Ende (114) des Trägers am Substrat (106) verankert ist, wobei sich der Teil des Trägers, der über der Vorderfläche (102) aufgehängt ist, zwischen dem ersten (112) und dem zweiten (114) Ende des Trägers befindet.

6. Elektrische Verbindungsvorrichtung (100) nach einem der vorhergehenden Ansprüche, bei der jedes elektrisch leitende Element (116) wenigstens einen Bereich aus elektrisch leitendem Material umfasst, von dem ein Ende eine Spitze oder mehrere Spitzen bildet, wobei jede Spitze eine im Wesentlichen gewölbte oder flache oder angespitzte Form hat.

7. Elektrische Verbindungsvorrichtung (100) nach einem der vorhergehenden Ansprüche, bei der der Träger jedes ersten elektrischen Verbindungselements (104) ferner wenigstens einen Verankerungsbereich (134) derart umfasst, dass eine erste (130) von den zwei Elektroden zwischen dem Verankerungsbereich (134) und dem Bereich aus piezoelektrischem Material (128) angeordnet ist, wobei der Verankerungsbereich (134) die Verankerung des Trägers am Substrat (106) gewährleistet.

8. Elektrische Verbindungsvorrichtung (100) nach einem der vorhergehenden Ansprüche, bei der der Träger jedes ersten elektrischen Verbindungselements (104) wenigstens einen elektrisch leitenden Bereich (118) umfasst, auf dem das elektrische leitende Element (116) angeordnet ist.

9. Elektrische Verbindungsvorrichtung (100) nach Anspruch 8, bei der der Träger jedes ersten elektrischen Verbindungselements (104) ferner wenigstens einen dielektrischen Bereich (122) umfasst, der zwischen dem elektrisch leitenden Bereich (118) und einer zweiten (124) von den zwei Elektroden angeordnet ist.

10. Elektrische Verbindungsvorrichtung (100) nach einem der Ansprüche 8 oder 9, ferner umfassend wenigstens einen elektrisch leitenden Durchgang (152), der das Substrat (106) durchsetzt und verbunden ist mit dem elektrisch leitenden Bereich (118) des Trägers von jedem ersten elektrischen Verbindungselement (104) und mit wenigstens einem zweiten elektrischen Verbindungselement (150), das auf einer Rückfläche (148) der elektrischen Verbindungsvorrichtung (100) angeordnet ist.

11. Elektrische Verbindungsvorrichtung (100) nach einem der Ansprüche 8 bis 10, bei der der elektrisch leitende Bereich (118) des Trägers von jedem ersten elektrischen Verbindungselement (104) einen Deckel von wenigstens einem Hohlraum (142) bildet, der in dem Träger angeordnet ist, wobei das elektrische leitende Element (116) über dem Hohlraum (142) angeordnet ist.

12. Elektrische Verbindungsvorrichtung (100) nach einem der vorhergehenden Ansprüche, ferner umfassend:
- mehrere dielektrische Schichten (110), die einander überlagert und auf dem Substrat (106) angeordnet sind und die Vorderfläche (102) der elektrischen Verbindungsvorrichtung (100) bilden,
- mehrere elektrische Zwischenverbindungsschichten (146), die in den dielektrischen Schichten (110) angeordnet sind und mit denen wenigstens die Elektroden (124, 130) von jedem ersten elektrischen Verbindungselement (104) verbunden sind.

13. Elektrische Verbindungsvorrichtung (100) nach einem der vorhergehenden Ansprüche, ferner umfassend wenigstens einen Speicher (144), der dazu ausgelegt ist, den Wert der elektrischen Spannung zu speichern, die an die Elektroden (124, 130) von jedem ersten elektrischen Verbindungselement (104) angelegt werden soll.

14. Verfahren zur Herstellung einer elektrischen Verbindungsvorrichtung (100), umfassend die Herstellung, ausgehend von einem Substrat (106), von einem oder mehreren ersten elektrischen Verbindungselementen (104) auf einer Vorderfläche (102) der elektrischen Verbindungsvorrichtung (100) derart, dass sie mit Kontaktpunkten (202) einer elektronischen Vorrichtung (200) gekoppelt werden können, an die die elektronische Verbindungsvorrichtung (100) angeschlossen werden soll, und die mechanisch von der elektrischen Verbindungsvorrichtung (100) unabhängig sind, wenigstens durch die Durchführung der folgenden Schritte:
- Herstellen wenigstens eines Bereichs aus Opfermaterial (162) auf der Vorderfläche (102);
- Herstellen wenigstens eines Trägers, von dem wenigstens ein erstes Ende (112) am Substrat (106) derart verankert ist, dass ein Teil des Trägers auf dem Bereich aus Opfermaterial (162) angeordnet ist, wobei der Träger wenigstens einen Bereich aus piezoelektrischem Material (128) umfasst, der zwischen zwei Elektroden (124, 130) angeordnet ist;
- Herstellen wenigstens eines elektrisch leitenden Elements (116) auf dem Teil des Trägers;
- Entfernen des Bereichs aus Opfermaterial (162), wodurch der Teil des Trägers derart freigelegt wird, dass der Bereich aus piezoelektrischem Material (128) in der Lage ist, den Teil des Trägers in bidirektionaler Weise im Wesentlichen orthogonal zur Vorderfläche (102) als Funktion eines Werts einer elektrischen Spannung zu verlagern, die an die Elektroden (124, 130) angelegt werden soll.

15. Verfahren nach Anspruch 14, ferner umfassend vor der Herstellung des oder der elektrischen Verbindungselements/Verbindungselemente (104) die Herstellung von mehreren dielektrischen Schichten (110), die einander überlagert und auf dem Substrat (106) angeordnet sind und die Vorderfläche (102) der elektrischen Verbindungsvorrichtung (100) bilden, sowie von mehreren elektrischen Zwischenverbindungsschichten (146), die in den dielektrischen Schichten (110) angeordnet sind, und mit denen wenigstens die Elektroden (124, 130) des oder der elektrischen Verbindungselements/Verbindungselemente (104) verbunden sind.

## Claims

1. An electrical connection device (100) comprising at least one substrate (106) and one or several first electrical connection elements (104) located on a front face (102) of the electrical connection device (100) such that they can be coupled to contact pads (202) of an electronic device (200) to which the electrical connection device (100) is intended to be connected and which are mechanically independent of the electrical connection device (100), each first electrical connection element (104) comprising:
- at least one support, of which at least one first end (112) is anchored to the substrate (106) such that part of the support is suspended above the front face (102), the support comprising at least a portion of piezoelectric material (128) located between two electrodes (124, 130) and capable of moving said part of the support in two directions approximately perpendicular to the front face (102) depending on a value of an electrical voltage intended to be applied onto the electrodes (124, 130);
- at least one electrical conducting element (116) located on said part of the support.

2. The electrical connection device (100) according to claim 1, in which the first electrical connection elements (104) are arranged according to a matrix with a pitch of less than about 100 µm.

3. The electrical connection device (100) according to one of previous claims, in which the support of each first electrical connection element (104) is elongated in shape and extends in a direction approximately parallel to the front face (102).

4. The electrical connection device (100) according to one of previous claims, in which the electrically conducting element (116) in each first electrical connection element (104) is located at a second end (114) of the support suspended above the front face (102).

5. The electrical connection device (100) according to one of claims 1 to 3, in which a second end (114) of the support is anchored to the substrate (106) in each first electrical connection element (104), said part of the support suspended above the front face (102) being located between the first end (112) and second end (114) of the support.

6. The electrical connection device (100) according to one of previous claims, in which each electrically conducting element (116) comprises at least one portion of electrically conducting material of which one end forms one or several probes, each probe possibly being rounded or plane or pointed.

7. The electrical connection device (100) according to one of previous claims, in which the support for each first electrical connection element (104) also comprises at least one anchor portion (134) such that a first electrode (130) of the two electrodes is located between said anchor portion (134) and the portion of piezoelectric material (128), the anchor portion (134) anchoring the support to the substrate (106).

8. The electrical connection device (100) according to one of previous claims, in which the support of each first electrical connection element (104) comprises at least one electrically conducting portion (118) on which the electrically conducting element (116) is located.

9. The electrical connection device (100) according to claim 8, in which the support of each first electrical connection element (104) also comprises at least one dielectric portion (122) located between the electrically conducting portion (118) and a second electrode (124) of the two electrodes.

10. The electrical connection device (100) according to one of claims 8 or 9, also comprising at least one electrically conducting via (152) passing through the substrate (106) and connected to the electrically conducting portion (118) of the support of each first electrical connection element (104) and to at least one second electrical connection element (150) located on a back face (148) of the electrical connection device (100).

11. The electrical connection device (100) according to one of claims 8 to 10, in which the electrically conducting portion (118) of the support of each first electrical connection element (104) forms a cover of at least one cavity (142) located in the support, the electrically conducting element (116) being located above the cavity (142).

12. The electrical connection device (100) according to one of previous claims, also comprising:
- several dielectric layers (110) superposed and arranged on the substrate (106) and forming the front face (102) of the electrical connection device (100),
- several electrical interconnection layers (146) located in the dielectric layers (110) and to which at least the electrodes (124, 130) of each first electrical connection element (104) are connected.

13. The electrical connection device (100) according to one of previous claims, also comprising at least one memory (144) capable of storing the value of the electrical voltage intended to be applied to the electrodes (124, 130) of each first electrical connection element (104).

14. A method for making an electrical connection device (100), comprising the production of one or several first electrical connection elements (104) from a substrate (106) on a front face (102) of the electrical connection device (100) such that they can be coupled to contact pads (202) of an electronic device (200) to which the electrical connection device (100) is intended to be connected, at least through the following steps:
- production of at least one portion of sacrificial material (162) on the front face (102);
- production of at least one support, of which at least one first end (112) is anchored to the substrate (106) such that part of the support is located on the portion of sacrificial material (162), the support comprising at least one portion of piezoelectric material (128) located between two electrodes (124, 130);
- production of at least one electrical connection element (116) on said part of the support;
- elimination of the portion of sacrificial material (162), releasing said part of the support such that the portion of piezoelectric material (128) is capable of moving said part of the support in two-directions, approximately perpendicular to the front face (102) depending on a value of an electrical voltage intended to be applied onto the electrodes (124, 130).

15. The method according to claim 14, also comprising the production of several dielectric layers (110) superposed and located on the substrate (106) and forming the front face (102) of the electrical connection device (100), and several electrical interconnection layers (146) located in the dielectric layers (110) and to which at least the electrodes (124, 130) of the first electrical connection element(s) (104) are connected, before production of the first electrical connection element(s) (104).
